# EUROPEAN PATENT APPLICATION

(11) **EP 1 383 254 A1**
(43) Date of publication of application: **21.01.2004**
(21) Application number: 02722744.6
(22) Date of filing: 24.04.2002
(51) Int. Cl.: H04B 10/06, H04L 1/00, H04L 25/49, H04L 25/02

(54) **RECEPTION APPARATUS**

(30) Priority: 27.04.2001 JP 2001133489
(71) Applicant: MITSUBISHI DENKI KABUSHIKI KAISHA, Tokyo 100-8310 (JP)
(72) Inventor: KUBO, Kazuo, c/o Mitsubishi Denki K. K., Tokyo 100-8310 (JP); UEMURA, Aritomo, c/o Mitsubishi Denki K. K., Tokyo 100-8310 (JP)
(74) Representative: Pfenning, Meinig & Partner GbR
(86) International application number: PCT/JP2002/004078
(87) International publication number: WO 2002/089365

(57) **Abstract**

An optical-electrical (OE) conversion unit (11) converts optical signals received through an optical transmission line into first electrical signals and second electrical signals. A multilevel identification unit (12) identifies the first electrical signals based on a plurality of identification levels, and produces multinary identification signals. A serial-parallel conversion circuit (13) converts the multinary identification signals into multinary parallel signals. An optical reception quality circuit (14) produces reliability information that indicates quality of optical signals from the second electrical signals. An error-correction decoding circuit (15) corrects errors based on the multinary parallel signals and the reliability information, and outputs error-corrected parallel signals.

## Description

### TECHNICAL FIELD

The present invention relates to an optical receiver in a long-haul and high-speed optical transmission system. Particularly, the present invention relates to an optical receiver capable of providing a high-quality transmission service compensating a quality deterioration of optical signals after being transmitted.

### BACKGROUND ART

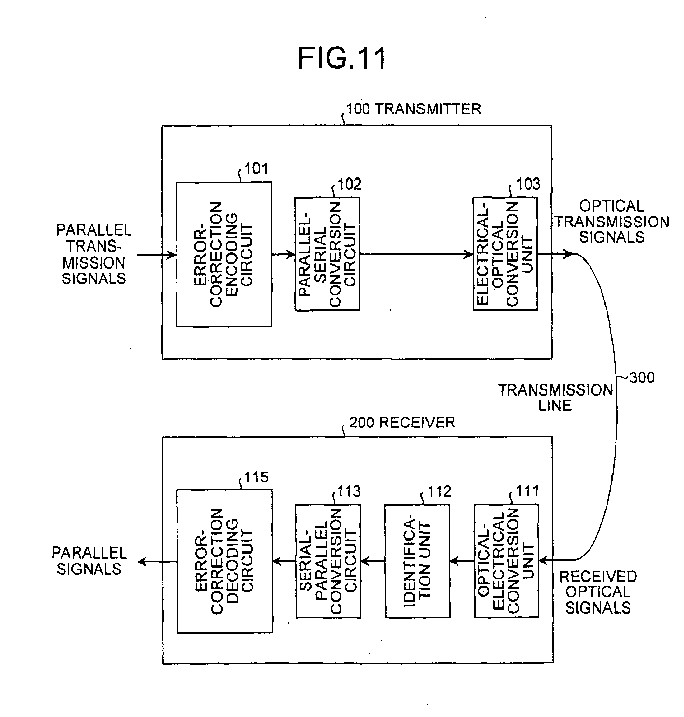

As a long-haul and high-speed optical transmission system, one of the widely-known systems is an optical transmission system recommended by ITU-T G.975. Fig. 11 is a block diagram representing the outline of the optical transmission system.

As shown in Fig. 11, an optical transmitter 100 is connected to an optical receiver 200 through a transmission line 300. The optical transmitter 100 includes an error-correction encoding circuit 101 and a parallel-serial conversion circuit 102, and an electrical-optical (EO) conversion unit 103. The optical receiver 200 includes an optical-electrical (OE) conversion unit 111, an identification unit 112, a serial-parallel conversion circuit 113, and an error-correction decoding circuit 115.

Parallel transmission signals input to the optical transmitter 100 are error-correction coded in the error-correction encoding circuit 101 using, for example, Reed Solomon codes, and the signals are output to the parallel-serial conversion circuit 102. The parallel-serial conversion circuit 102 converts the error-correction-coded transmission signals into high-speed multiplexed signals and outputs the multiplexed signals to the EO conversion unit 103. The EO conversion unit 103 converts electrical signals into optical signals and outputs the optical signals to the transmission line 300.

On the other hand, the optical receiver 200 receives optical signals through the transmission line 300 and converts the optical signals into electrical signals, and outputs the electrical signals to the identification unit 112. The identification unit 112 identifies the converted electrical signals by determining mark/space based on an identification level L. The serial-parallel conversion circuit 113 converts the identified signals into parallel signals and outputs the parallel signals to the error-correction decoding circuit 115. The error-correction decoding circuit 115 corrects bit errors caused by quality deterioration of the optical signals in the transmission line 300 and outputs bit-error-corrected signals as parallel signals.

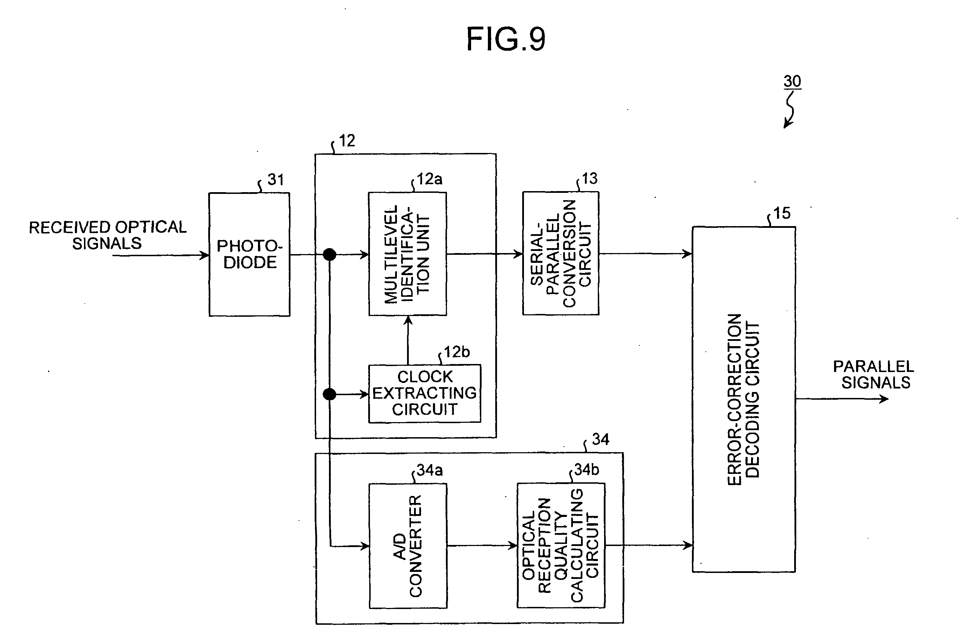

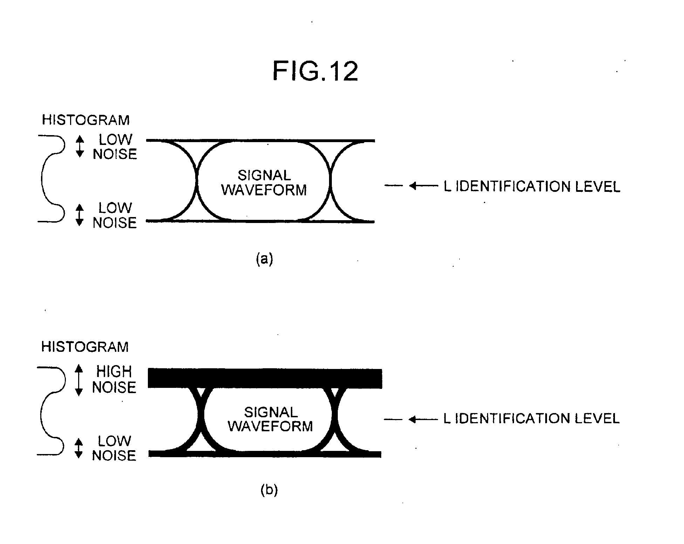

Fig. 12 illustrates the relation between waveforms of the electrical signals input to the identification unit 112 and the identification level L. As shown in Fig. 12 (a), if the quality deterioration of the optical signals input through the transmission line 300 is small enough and the reception conditions are good, the eye diagram of the electrical signal waveform becomes wide open. However, if the quality deterioration of the optical signals is severe and the reception conditions are poor, the eye diagram of the electrical signal waveform becomes narrow, as shown in Fig. 9 (b). Particularly, the mark side shows a significant deterioration. Therefore, in the identification unit 112, the identification level L that is used to determine the mark-space is preset so that the best bit error rate (BER) is obtained in poor reception conditions.

Since the optical receiver 200 in the conventional optical transmission system employs a binary system of mark and space determined by a single identification level L, an improvement is conducted, such as adopting a high ratio of the redundant bit to the information bit in the error correction code by increasing the transmission speed.

However, since there is a trade-off between increase rate of the transmission speed and the amount of deterioration of the optical transmission quality, it is quite difficult to improve the transmission quality in the conventional optical receiver, resulting in a technical limit to the improvement.

Therefore, it is an object of the present invention to implement an optical receiver in the optical transmission system that can provide a high-quality transmission service, compensating quality deterioration of optical transmission signals without accompanying an increase of the transmission speed.

### DISCLOSURE OF THE INVENTION

The optical receiver according to the present invention includes an optical-electrical (OE) conversion unit that converts optical signals received through a transmission line into first electrical signals and second electrical signals; a multilevel identification unit that identifies the first electrical signals based on a plurality of identification levels and produces multinary identification signals based on the result of identification of the first electrical signals; an optical reception quality determining unit that produces reliability information that indicates quality of the optical signals based on the second electrical signals; and an error-correction decoding unit that corrects errors based on the multinary identification signals and the reliability information, and outputs error-corrected signals.

According to the present invention, the OE conversion unit converts the optical signals received through a transmission line into the first electrical signals and the second electrical signals. The multilevel identification unit identifies the first electrical signals based on a plurality of identification levels and produces the multinary identification signals based on the result of identification of the first electrical signals. The optical reception quality determining unit produces reliability information that indicates quality of the optical signals based on the second electrical signals. The error-correction decoding unit corrects errors based on the multinary identification signals and the reliability information, and outputs error-corrected signals.

The optical receiver according to the present invention includes an OE conversion unit that converts optical signals received through a transmission line into first electrical signals and second electrical signals; an optical reception quality determining unit that determines quality of the optical signals and produces reliability information that indicates the quality, based on the first electrical signals; a multilevel identification unit that variably controls a plurality of identification levels to identify the second electrical signals, based on the reliability information, identifies the second electrical signals based on the varied plurality of identification levels, and produces multinary identification signals based on the result of identification of the second electrical signals; and an error-correction decoding unit that corrects errors based on the multinary identification signals, and outputs error-corrected signals.

According to the present invention, when the optical reception quality determining unit produces reliability information that indicates quality of the optical signals from the first electrical signals, the multilevel identification unit identifies the second electrical signals by variably controlling the plurality of identification levels in accordance with the optical reception quality that is indicated by the reliability information. The error-correction decoding unit corrects errors based on the multinary identification signals that are weighted in accordance with the quality of the optical signals input from the multilevel identification unit.

The optical receiver according to the present invention includes a first optical coupler that splits optical signals received through a transmission line into two; a first photodiode that converts one of the split lights into electrical signals; a clock extracting circuit that extracts a clock from output signals of the first photodiode; a multilevel identification unit that identifies output signals from the first photodiode based on the plurality of identification levels at a timing of the clock and outputs multinary serial signals based on the result of identification of the output signals of the first photodiode; a serial-parallel conversion circuit that converts the multinary serial signals into multinary parallel signals; a second optical coupler that extracts a desired wavelength component from the other split light from the first optical coupler; a second photodiode that converts output lights from the second optical coupler into electrical signals; an A/D converter that converts output signals from the second photodiode into digital signals; an optical reception calculating circuit that calculates, based on the digital signals, reliability information that indicates quality of the optical signals; and an error-correction decoding circuit that corrects errors based on the multinary identification signals and the reliability information, and outputs error-corrected signals.

According to the present invention, the light embedding optical signals received through a transmission line is split into two. One of the split lights is converted into electrical signals. The multilevel identification unit identifies the electrical signals at the extracted clock timing, based on the plurality of identification levels. The multinary parallel signals that are results of the identification are given to the error-correction decoding circuit. The electrical signals converted from a desired wavelength component that is extracted from the other split light are converted into digital signals by the A/D converter in order to determine quality of the optical signals. In the optical reception calculating circuit, reliability information that indicates quality of the optical signals is calculated based on the digital signals, and given to the error-correction decoding circuit. The error-correction decoding circuit corrects errors based on the multinary parallel signals in accordance with the optical reception quality that is indicated by the reliability information.

The optical receiver according to the present invention includes a first optical coupler that splits optical signals received through a transmission line into two; a second optical coupler that extracts a desired wavelength component from a split light from the first optical coupler; a first photodiode that converts output light from the second optical coupler into electrical signals; an A/D converter that converts output signals of the first photodiode into digital signals; an optical reception calculating circuit that calculates, based on the digital signals, reliability information that indicates the optical reception quality; an identification value control circuit that produces identification level control signals to variably control values of the plurality of identification levels in accordance with the reliability information; a second photodiode that converts the other split light from the first optical coupler into electrical signals; a clock extracting circuit that extracts a clock from the output signals of the second photodiode; a multilevel identification unit that identifies the output signals of the second photodiode based on the plurality of identification levels at a timing of the clock, and outputs multinary serial signals based on the result of identification of the output signals of the second photodiode; a serial-parallel conversion circuit that converts the multinary serial signals into multinary parallel signals; and an error-correction decoding circuit that corrects errors using the parallel signals, and outputs error-corrected parallel signals.

According to the present invention, the light of optical signals received through a transmission line is split into two. The electrical signals converted from a desired wavelength component that is extracted from the other split light are converted into digital signals by the A/D converter in order to determine quality of the optical signals. In the optical reception quality calculating circuit, reliability information that indicates quality of the optical signals is calculated based on the digital signals. The identification level control signals based on the reliability information are given to the multilevel identification unit. The multilevel identification unit identifies the electric signals by variably controlling a plurality of identification levels in accordance with the identification level control signals, namely, variably controlling the plurality of identification levels based on the optical reception quality that is indicated by the reliability information, at a clock timing that is extracted from the electrical signals converted from the other split light. The identified multinary serial signals are converted into parallel signals, and are given to the error-correcting decoding circuit in which errors are corrected based on the optical reception quality.

The optical receiver according to the present invention includes a photodiode that converts optical signals received through a transmission line into electrical signals; a clock extracting circuit that extracts a clock from the electrical signals; a multilevel identification unit that identifies the electrical signals based on a plurality of identification levels at a timing of the clock, and outputs multinary serial signals; a serial-parallel conversion circuit that converts the multinary serial signals into multinary parallel signals; an A/D converter that converts the electrical signals into digital signals; an optical reception quality calculating circuit that calculates, based on the digital signals, reliability information that indicates quality of the optical signals; and an error-correction decoding circuit that corrects errors based on the multinary identification signals and the reliability information, and outputs error-corrected signals.

According to the present invention, the multilevel identification unit identifies the electrical signals based on the plurality of identification levels at the clock timing extracted from the electrical signals converted from the optical signals received through a transmission line. The identified multinary serial signals are converted into parallel signals and given to the error-correction decoding circuit. On the other hand, the electrical signals that are converted from the optical signals received through the transmission line are converted into digital signals by the A/D converter in order to determine quality of the optical signals. In the optical reception quality calculating circuit, reliability information that indicates quality of the optical signals is calculated from the digital signals and given to the error-correction decoding circuit. The error-correction decoding circuit corrects errors based on the multinary parallel signals and the optical reception quality that is indicated by the reliability information.

The optical receiver according to the present invention includes a photodiode that converts optical signals received through a transmission line into electrical signals; an A/D converter that converts the electrical signals into digital signals; an optical reception quality calculating circuit that calculates, based on the digital signals, reliability information that indicates quality of the optical signals; an identification value control circuit that produces identification level control signals to variably control values of a plurality of identification levels in accordance with the reliability information; a clock extracting circuit that extracts a clock from the electrical signals; a multilevel identification unit that outputs multinary serial signals by variably controlling the identification levels in accordance with the identification level control signals when identifying the electrical signals based on a plurality of identification levels at the clock timing; a serial-parallel conversion circuit that converts the multinary serial signals into multinary parallel signals; and an error-correction decoding circuit that corrects errors using the parallel signals, and outputs error-corrected parallel signals.

According to the present invention, the electrical signals converted from the optical signals received through a transmission line are converted into digital signals by the A/D converter in order to determine quality of the optical signals. In the optical reception quality calculating circuit, reliability information that indicates quality of the optical signals is calculated based on the digital signals. The identification level control signals based on the reliability information are given to the multilevel identification unit. The multilevel identification unit identifies the electrical signals by variably controlling a plurality of identification levels in accordance with the identification control signals, namely, variably controlling the identification levels based on the optical reception quality at a timing of the clock that is extracted from the electrical signals. The identified multinary serial signals are converted into multinary parallel signals, and given to the error-correction decoding circuit in which errors are corrected based on the optical reception quality.

In the optical receiver according to the present invention, the reliability information is any single information among the optical reception power, the optical S/N ratio, and the optical wavelength or information of any random combination of the optical reception power, the optical S/N ratio, and the optical wavelength.

According to the present invention, a single information among the optical reception power, the optical S/N ratio, and the optical wavelength or information of any random combination of the optical reception power, the optical S/N ratio, and the optical wavelength is used as the reliability information.

In the optical receiver according to the present invention, the reliability information is produced in synchronization with the identification timing of the clock.

According to the present invention, the reliability information is produced in synchronization with the identification timing of the clock.

In the optical receiver according to the present invention, the reliability information is produced for every single symbol by using an error-correction code that treats a set of n bits (n is a positive integer) as one symbol.

According to the present invention, the reliability information is produced for every single symbol by using an error-correction code that treats a set of n bits (n is a positive integer) as one symbol.

### BRIEF DESCRIPTION OF THE DRAWINGS

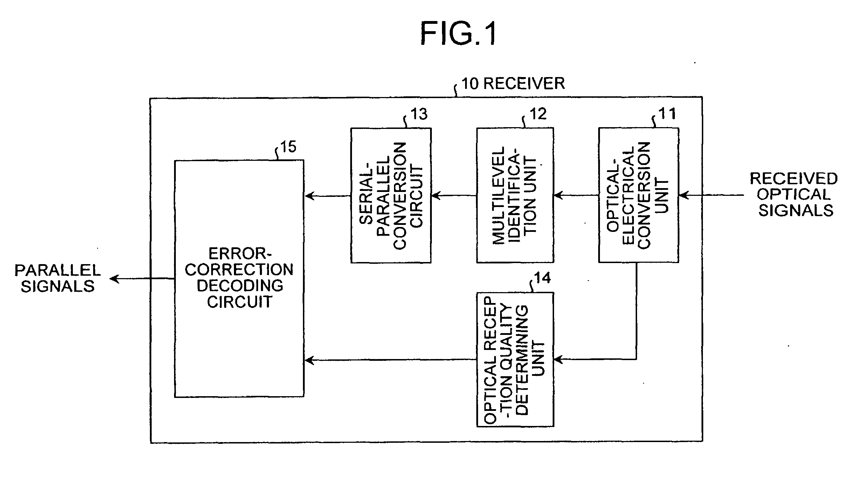

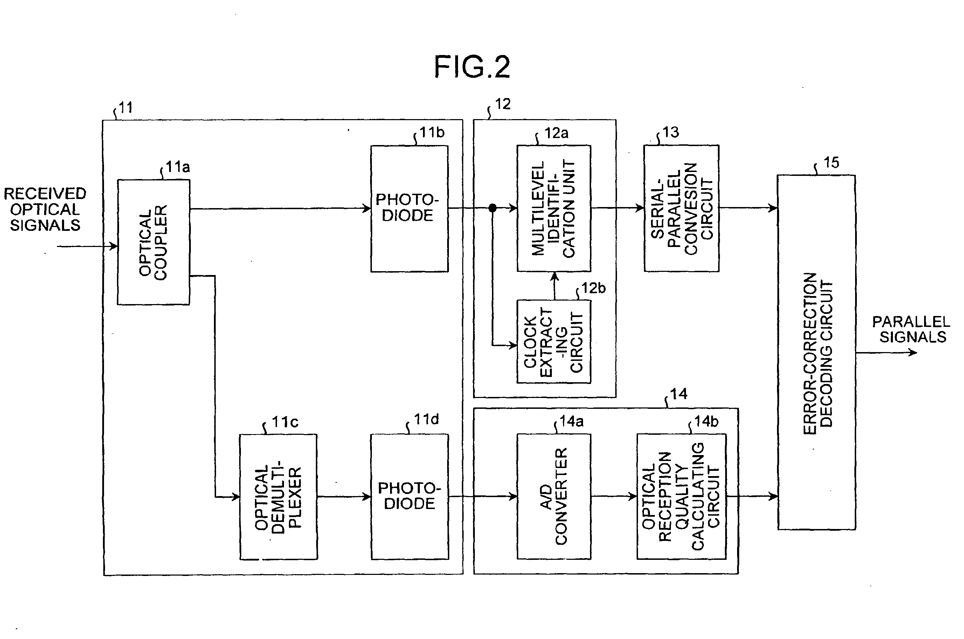

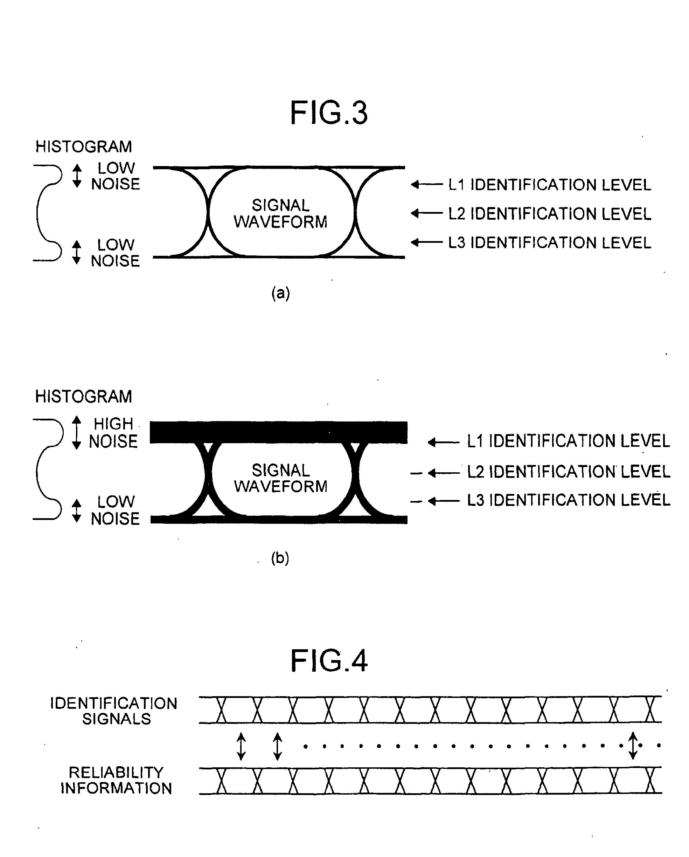

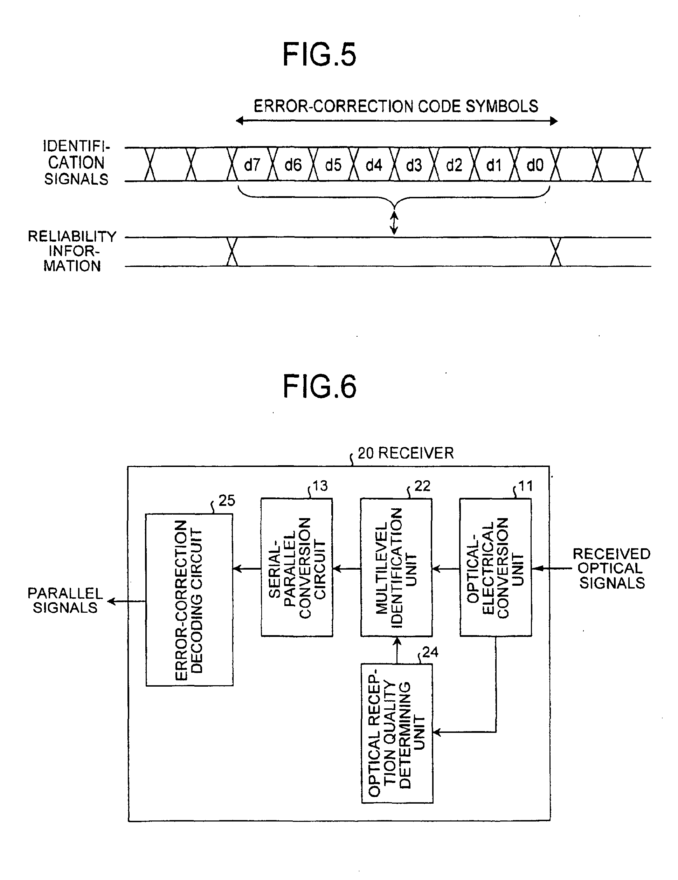

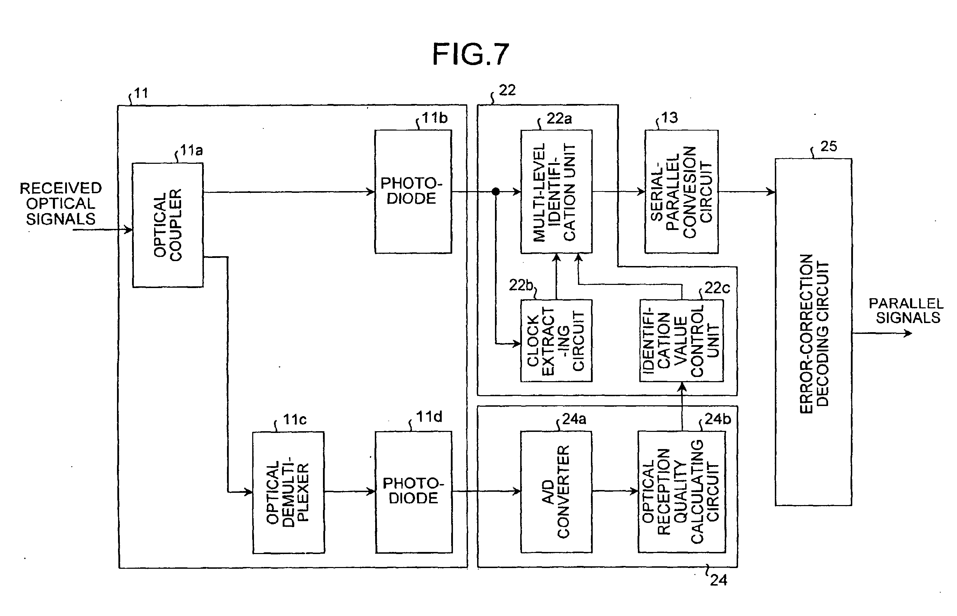

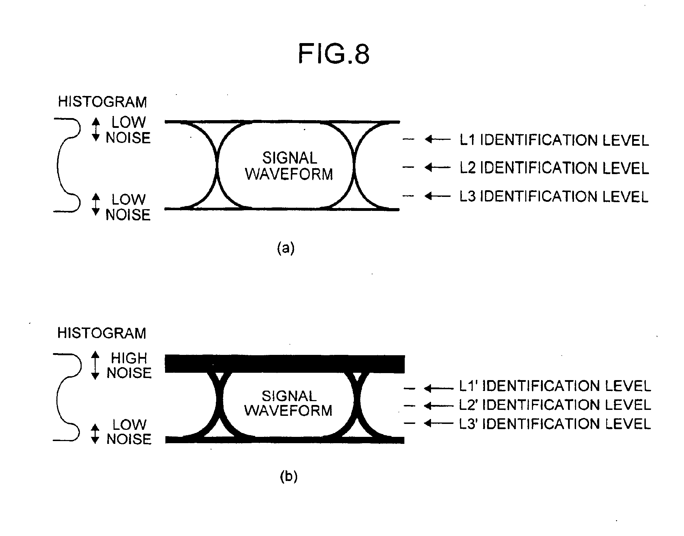

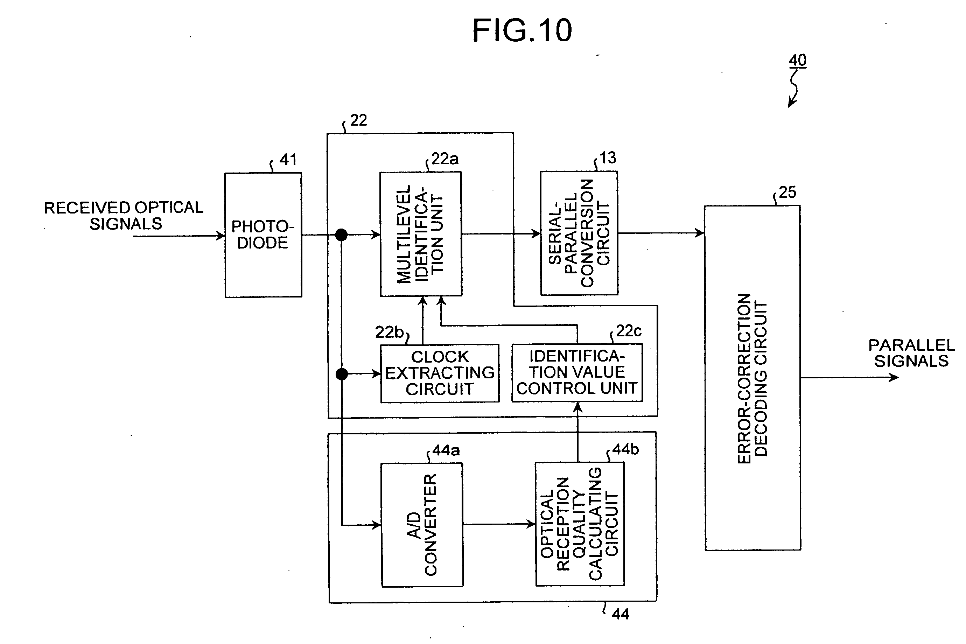

Fig. 1 is a block diagram representing the outline of optical receiver according to the first embodiment of the present invention; Fig. 2 is a detailed block diagram of the optical receiver shown in Fig. 1; Fig. 3 illustrates a relation between waveforms and identification levels of the electrical signals input to the multilevel identification unit; Fig. 4 is a timing chart illustrating a relation between identification signals and reliability information; Fig. 5 is a timing chart illustrating another example of relation between identification signals and reliability information; Fig. 6 is a block diagram representing the outline of optical receiver according to the second embodiment of the present invention; Fig. 7 is a detailed block diagram of the optical receiver shown in Fig. 6; Fig. 8 illustrates a relation between waveforms and identification levels of the electrical signals input to the multilevel identification unit; Fig. 9 is a block diagram representing the outline of optical receiver according to the third embodiment of the present invention; Fig. 10 is a block diagram representing the outline of optical receiver according to the fourth embodiment of the present invention; Fig. 11 is a block diagram representing the outline of optical transmission system including a conventional optical receiver; and Fig. 12 illustrates a relation between waveforms and identification levels of the electrical signals input to the identification unit shown in Fig. 11.

### BEST MODE FOR CARRYING OUT THE INVENTION

Exemplary embodiments of the present invention are explained below referring to the accompanying drawings.

### First Embodiment

Fig. 1 is a block diagram representing the outline of optical receiver according to the first embodiment of the present invention. The optical receiver 10 is equivalent to the optical receiver 200 shown in Fig. 11, and optical signals are input to the optical receiver 10 through the optical transmitter 100 and the transmission line 300 in Fig. 11. As shown in Fig. 1, the optical receiver 10 has an optical-electrical (OE) conversion unit 11, a multilevel identification unit 12, a serial-parallel conversion circuit 13, an optical reception quality determining unit 14, and an error-correction decoding circuit 15.

The OE conversion unit 11 converts optical signals received through the transmission line 300 into first electrical signals and second electrical signals. The first electrical signals are output to the multilevel identification unit 12, and the second electrical signals are output to the optical reception quality determining unit 14.

The multilevel identification unit 12 identifies the first electrical signals based on a plurality of identification levels from L1 to L3, and output the signals to the serial-parallel conversion circuit 13 as multinary identification signals. The serial-parallel conversion circuit 13 conducts a serial-parallel conversion for the input multinary identification signals, and outputs the signals to the error-correction decoding circuit 15 as multinary parallel signals.

On the other hand, the optical reception quality determining unit 14 produces reliability information that indicates quality of the optical signals based on the second electrical signals input from the OE conversion unit 11, and outputs the reliability information to the error-correction decoding circuit 15. The reliability information is produced as any single information among the optical reception power, the optical S/N ratio, and the optical wavelength or a random combination of the optical reception power, the optical S/N ratio, and the optical wavelength.

The error-correction decoding circuit 15 corrects errors based on the multinary parallel signals that are identified signals of the first electrical signals based on the plurality of identification levels from L1 to L3 using the multilevel identification unit 12 referring to the reliability information input from the optical reception quality determining unit 14. The parallel signals after the error-correction decoding are output to the next stage of signal processing system that is not shown in the figure. Thus, the error-correction decoding circuit 15 is able to enhance the ability of error-correction and correct errors with a high probability, even when the optical reception quality in the transmission line 300 is deteriorated.

Fig. 2 is a detailed block diagram of the optical receiver shown in Fig. 1. The OE conversion unit 11 in Fig. 2 includes an optical coupler 11a, a photodiode 11b, an optical demultiplexer (DEMUX) 11c, and a photodiode 11d.

The optical coupler 11a splits the optical signals received through the transmission line 300 into two branches at a desired ratio, and outputs one of the split lights to the photodiode 11 b and the other split light to the optical DEMUX 11c. The photodiode 11b converts one portion of the optical signals split by the optical coupler 11 a into electrical signals and outputs the electrical signals to the multilevel identification unit 12 as first electrical signals.

The optical DEMUX 11c extracts a desired wavelength component by sweeping the other portion of optical signals split by the optical coupler 11a and outputs the component to the photodiode 11d. The photodiode 11d converts the optical signals of the extracted wavelength into electrical signals and outputs the electrical signals to the optical reception quality determining unit 14 as second electrical signals.

The multilevel identification unit 12 includes a multilevel identification unit 12a and a clock extracting circuit 12b. The clock extracting circuit 12b extracts a clock component from the first electrical signals output from the photodiode 11 b and outputs the extracted clock (hereinafter, "reception extracted clock") to multilevel identification unit 12a.

The multilevel identification unit 12a uses a plurality of identification levels from L1 to L3 and identifies the first electrical signals output from the photodiode 11b with a timing of the reception extracted clock and using the plurality of identification levels from L1 to L3. The multilevel identification unit 12a outputs the identified multinary serial signals to the serial-parallel conversion circuit 13. The serial-parallel conversion circuit 13 converts the multinary serial signals into low-speed multinary parallel signals and outputs the parallel signals to the error-correction decoding circuit 15.

On the other hand, the optical quality determining unit 14 includes an A/D converter 14a and an optical reception quality calculating circuit 14b. The A/D converter 14 converts the second electrical signals from the photodiode 11 b into digital signals and outputs the digital signals to the optical reception quality calculating unit 14b. The optical reception quality calculating unit 14b produces reliability information based on the digital signals from the A/D converter 14a and outputs the reliability information to the error-correction decoding circuit 15. The optical reception quality calculating circuit 14b produces any single information among the optical reception power, the optical S/N ratio, and the optical wavelength or any random combination of the optical reception power, the optical S/N ratio, and the optical wavelength as the reliability information and outputs the reliability information to the error-correction decoding circuit 15.

Thereafter, the error-correction decoding circuit 15 corrects errors in the multinary parallel signals input from the serial-parallel conversion circuit 13, based on the reliability information from the optical reception quality calculating circuit 14b and outputs as the parallel signals to the next stage of signal processing system that is not shown in the figure

Fig. 4 illustrates a relation between waveforms of the first electrical signals and the plurality of identification levels from L1 to L3. Fig. 5 illustrates a relation between the identification signals identified by the plurality of identification levels from L1 to L3 and the reliability information.

One side of the split optical signals into a desired ratio by the optical coupler 11a is converted to the first electrical signals and output to the clock extracting circuit 12b and the multilevel identification unit 12a.

When the quality of the optical signals is good enough, the waveforms of the first electrical signals input to the multilevel identification unit 12a shows a good eye diagram and noise distributions in the mark side and the space side are nearly symmetric, as shown in Fig 3 (a). On the other hand, if the quality of the optical signals is deteriorated, the mark side deteriorates significantly and the noise distributions become asymmetric, as shown in Fig. 3 (b).

The multilevel identification unit 12a identifies the first electrical signals at the extracted clock timing from the clock extracting circuit 12b based on three identification levels from L1 to L3. The identification level L2 is located at the center of the eye diagram and the identification level L1 and L3 are arranged above and below L2. Each of the identification levels from L1 to L3 is arranged with a large interval in order to fully identify openings of the eye diagram. The multilevel identification unit 12a identifies the binary first electrical signals by three different values, namely, three identification levels from L1 to L3, and outputs quadnary signals (0, 1, 2, 3) to the serial-parallel conversion circuit 13.

The quadnary signals are represented as 00, 01, 10, and 11 using two bits of binary notation for each level, and the serial-parallel conversion circuit 13 converts the values from serial to parallel and outputs the parallel quadnary signals to the error-correction decoding circuit 15.

On the other hand, the other side of the split optical signals into the desired ratio by the optical coupler 11 a is output to the optical DEMUX 11c. Optical signals of the desired wavelength component filtered by the DEMUX 11c are converted into electrical signals by the photodiode 11d. The electrical signals are output to the A/D converter 14a as the second electrical signals and converted into digital signals by the A/D converter 14a and output to the optical reception quality calculating unit 14b.

The optical reception quality calculating unit 14b calculates, for example, any single information among the optical reception power, the optical S/N ratio, and the optical wavelength or any random combination of the optical reception power, the optical S/N ratio, and the optical wavelength, and outputs the results of the calculation to the error-correction decoding circuit 15 as the reliability information that indicates quality of the optical signals. The reliability information is produced for the each identification timings, as shown in Fig. 4, and input to the error-correction decoding circuit 15 as parallel signals being synchronized with the parallel quadnary signals output from the serial-parallel conversion circuit 13.

The error-correction decoding circuit 15 corrects error bits existing in the received signals based on the parallel quadnary signals and the reliability information, and outputs parallel signals. If the optical reception quality deteriorates due to a decline of the optical reception power, a deterioration of the optical S/N ratio, or a deviation of the optical wavelength, the waveforms of the electrical signals deteriorate conspicuously as shown in Fig. 3 (b), and the noise distribution becomes asymmetric. In this case, the three identification levels from L1 to L3 have constant values, and unlike a case when the optical reception quality is good as shown in Fig. 3 (a), weights of each quadnary signals change.

In such a case, since the error-correction decoding circuit 15 corrects bit errors base on the reliability information, each bit error can be precisely detected and corrected even if the optical reception quality is poor, in other words, even if the bit error rate is high.

Since the error-correction decoding circuit 15 corrects errors using parallel multinary signals developed in parallel and parallelized reliability information, the error-correction decoding circuit 15 can be implemented using CMOS-LSI that can make a large-scale integration and low power consumption realized. As a result, a miniaturization and a low power consumption of the optical receiver 10 become possible.

When the error correction code symbols that treat a set of 8 bits as one symbol are applied, what is necessary is to produce the reliability information for each symbol, as shown in Fig. 5. In this case, a structure of the A/D converter 14a and the optical reception quality calculating unit 14b can be simplified.

Furthermore in the case of processing the wavelength-multiplexed optical signals, splitting of the light can be carried out before the wavelength demultiplexing.

### Second Embodiment

In the first embodiment, errors in the quadnary signals are corrected based on the quadnary signals that are identified by a plurality of fixed identification levels from L1 to L3 and the reliability information. However, in the second embodiment, the plurality of identification levels from L1 to L3 are changed based on the reliability information and errors are corrected based on the newly obtained quadnary signals.

Fig. 6 is a block diagram of the optical receiver according to the second embodiment of the present invention. The optical receiver 20 shown in Fig. 6 has the multilevel identification unit 22 instead of the multilevel identification unit 12 in the optical receiver 10 shown in Fig. 1. The reliability information produced by the optical reception quality determining unit 24, which has the same function as the optical reception quality determining unit 14, is input to the multilevel identification unit 22. The error-correction decoding circuit 25 is provided instead of the error-correction decoding circuit 15. The other components are the same as those of the first embodiment and same numbers are assigned on the same components.

As shown in Fig. 6, the multilevel identification unit 22 identifies the first electrical signals from the OE conversion unit 11 based on a plurality of identification levels from L1 to L3. In this case, the plurality of identification levels from L1 to L3 are variably controlled in accordance with the reliability information from the optical reception quality determining unit 24 and the multilevel identification unit 22 produces multinary identification signals according to the newly obtained plurality of identification levels.

The error-correction decoding circuit 25 corrects errors based on the multinary parallel signals identified by the plurality of identification levels that have been changed in accordance with the reliability information and outputs error-corrected parallel signals to the next stage of signal processing system that is not shown in the figure. Thus, the error-correction decoding circuit 25 can securely correct errors with high error-correction ability and a high probability even when the optical reception quality deteriorates, just like the first embodiment.

Fig. 7 is a detailed block diagram of the optical receiver shown in Fig. 6. In Fig. 7, the optical reception quality determining unit 24 includes an A/D converter 24a and an optical reception quality calculating circuit 24b and has the same structure as the optical reception quality determining unit 14. However, unlike the optical reception quality calculating circuit 14b, the optical reception quality calculating circuit 24b outputs the produced reliability information to the multilevel identification unit 22 and does not output the produced reliability information to an error-correction decoding circuit 25.

On the other hand, the multilevel identification unit 22 includes a multilevel identification unit 22a, a clock extracting circuit 22b, and an identification value control circuit 22c. The structure of the clock extracting circuit 22b is the same as that of the clock extracting circuit 12b. The identification value control circuit 22c produces identification level control signals that control the variable identification levels L1, L2, and L3 based on the reliability information from the optical reception quality calculating circuit 24b and output the identification level control signals to the multilevel identification unit 22a.

The multilevel identification unit 22a identifies the first electrical signals from the photodiode 11b at the extracted clock timing from the clock extracting circuit 22b based on the plurality of identification levels from L1' to L3' that have been changed by the identification level control signals. And the multilevel identification unit 22a outputs the identified serial quadnary signals to the serial-parallel conversion circuit 13.

The error-correction decoding circuit 25 corrects errors based on the parallel quadnary signals from the serial-parallel conversion circuit 13 and outputs parallel signals to the next stage of signal processing system that is not shown in the figure.

The relation between waveforms of the first electrical signals and the identification levels are explained referring to Fig. 8. The waveforms of the first electrical signals input to the multilevel identification unit 22a possesses good eye apertures if the quality of the optical signals is good as shown in Fig. 8 (a) and the noise distributions in the mark side and the space side are almost symmetric. On the other hand, if the quality of the optical signals is poor, the marked side deteriorates significantly and the noise distributions become asymmetric as shown in Fig. 8 (b).

The multilevel identification unit 22a identifies the first electrical signals at the extracted clock timing from the clock extracting circuit 22b, based on the variably controlled identification levels from L1' to L3' and outputs the identified quadnary serial signals to the serial-parallel conversion circuit 13. The multilevel identification unit 22a variably controls identification levels in accordance with the identification level control signals from the identification value control circuit 22c.

For example, if the quality of the optical signals is good as shown in Fig. 8 (a), the three identification levels from L1 to L3 are arranged such that L2 comes to the center of the eye diagram and L1 and L3 are controlled to come above and below L2 with a large distance each other, respectively. On the other hand, if the quality of the optical signals is poor as shown in Fig. 8 (b), identification level L2' is positioned at the center of the eye aperture in the same manner as the identification level L2, however the upper and lower identification levels L1' and L3' are controlled to be arranged lopsidedly around the center of the eye apertures with a closer distance one another according to the width of the eye diagram that is narrowed.

As explained above, the multilevel identification unit 22a produces quadnary signals (0, 1, 2, 3) weighted in accordance with the optical reception quality and outputs the signals to the serial-parallel conversion circuit 13. The error-correction decoding circuit 25 corrects error bits in the received signals based on the parallel quadnary signals from the serial-parallel conversion circuit 13 and outputs corrected signals as parallel signals.

If the optical reception quality deteriorates due to a decline of the optical reception power, a deterioration of the optical S/N ratio, and a deviation of the optical wavelength, the waveforms of the electrical signals in the mark side deteriorate significantly as shown in Fig. 8 (b) and the noise distributions become asymmetric. In the second embodiment, since the identification levels are appropriately controlled in accordance with the optical reception quality, even if the optical reception quality is poor, in other words, even when the bit error rate is high, bit errors are precisely detected and corrected.

In this case, as the error-correction decoding circuit 25 corrects errors based on the parallel multinary signals developed in parallel, just like the first embodiment, the error-correction decoding circuit 25 can be implemented using CMOS-LSI and the miniaturization and the low power consumption of the optical receiver become possible.

### Third Embodiment

The third embodiment has a simplified structure of the OE conversion unit 11 in the first embodiment. Fig. 9 is a block diagram of the optical receiver according to the third embodiment of the present invention. As shown in Fig. 9, the photodiode 31 in the optical receiver 30 replaces the OE conversion unit 11 in the first embodiment. In other words, the optical coupler 11 a, the optical DEMUX 11c, and the photodiode 11d, which constituted the OE conversion unit 11 in the first embodiment, are eliminated in the structure of the third embodiment. Along with this structural simplification, the electrical signals are input from the photodiode 31 to the A/D converter 34a of the optical reception quality determining unit 34, unlike the case where the A/D converter 14a is used. The other components are the same as those of the first embodiment and the same numbers are assigned to the same components.

In the third embodiment, the electrical signals are not such electrical signals of wavelength-selected signal component only as signals from the photodiode 11d in the first embodiment. However, since the photodiode 31 includes most component of the wavelength-selected signal, the reliability information to evaluate the optical reception quality can be obtained just like the first embodiment. As a result, the third embodiment exerts the same advantageous effects as the first embodiment using a simple structure.

### Fourth Embodiment

The fourth embodiment has a simplified structure of the second embodiment having a similar relation between the first embodiment and the third embodiment. Fig. 10 is a block diagram of the optical receiver according to the fourth embodiment of the present invention.

As shown in Fig. 10, the photodiode 41 in the optical receiver 40 replaces the OE conversion unit 11 in the second embodiment. In other words, the optical coupler 11a, the optical DEMUX 11c, and the photodiode 11d, which constituted the OE conversion unit 11 in the second embodiment, are eliminated in the structure of the fourth embodiment. Along with this structural simplification, the electrical signals are input from the photodiode 41 to the A/D converter 44a of the optical reception quality determining unit 44, unlike the case where the A/D converter 24a is used. The other components are the same as those of the second embodiment and the same numbers are assigned to the same components.

In the fourth embodiment, the electrical signals are not such electrical signals of wavelength-selected signal component only as signals from the photodiode 11d in the second embodiment. However, since the photodiode 41 includes most component of the wavelength-selected signal, the reliability information to evaluate the optical reception quality can be obtained just like the second embodiment. As a result, the fourth embodiment exerts the same advantageous effects as the second embodiment using a simple structure.

As explained above, according to the present invention, since the optical receiver can correct errors based on the multinary identification signals in accordance with the optical reception quality that is indicated by the reliability information, the optical receiver can correct errors with a high probability even if the optical reception quality is deteriorated. Therefore, the present invention can realize a long-haul and high-speed optical transmission system that provides a high-quality transmission service compensating quality deterioration of the optical transmission signals.

According to the present invention, since the optical receiver can correct errors based on the multinary identification signals that are weighted in accordance with quality of the optical signals, the optical receiver can correct errors with a high probability even if the optical reception quality is deteriorated. Therefore, the present invention can realize a long-haul and high-speed optical transmission system that provides a high-quality transmission service compensating quality deterioration of the optical transmission signals.

According to the present invention, the multinary parallel signals are produced by splitting the optical signals received through a transmission line into two lights and identifying the electrical signals converted from one of the split lights based on a plurality of identification levels. The reliability information that indicates quality of the optical signals is produced from the electrical signals converted from a wavelength-selected signal component from other of the split lights. Therefore, the error correction by the multinary parallel signals is conducted in accordance with the optical reception quality that is indicated by the reliability information. This kind of error-correction decoding circuit can be implemented using CMOS-LSI that can make a large-scale integration and low power consumption realized. As a result, a miniaturization and a low power consumption of the optical receiver become possible.

According to the present invention, the optical signal received through a transmission line is split into two lights. The desired wavelength component of optical signals that is extracted from one of the split lights is converted into electrical signals. The reliability information that indicates quality of the optical signals is produced from the electrical signals, and the identification level control signals based on the reliability information are given to the multilevel identification unit. The multilevel identification unit variably controls, in accordance with the optical reception quality that is indicated by the reliability information, the plurality of identification levels that identify the electrical signals converted from other of the split lights, and the unit identifies the electrical signals based on the identification levels: Then, the multinary parallel signals that are weighted in accordance with the optical reception quality are produced and the signals are given to the error-correction decoding circuit. Therefore, the error-correction decoding circuit can correct errors in accordance with the optical reception quality. This kind of error-correction decoding circuit can be implemented using CMOS-LSI that can make a large-scale integration and low power consumption realized. As a result, a miniaturization and a low power consumption of the optical receiver become possible.

According to the present invention, the electrical signals converted from the optical signals received through a transmission line are identified based on the plurality of identification levels. The identified multinary serial signals are converted into parallel signals and given to the error-correction decoding circuit. On the other hand, the electrical signals are converted into digital signals that are used to determine quality of the optical signals. The reliability information that indicates quality of the optical signals is produced based on the digital signals and given to the error-correction decoding circuit. Therefore, the error-correction decoding circuit can correct errors based on the multinary parallel signals and the optical reception quality that is indicated by the reliability information. This kind of error-correction decoding circuit can be implemented using CMOS-LSI that can make a large-scale integration with a low power consumption realized. As a result, a miniaturization and an electricity consumption reduction of the optical receiver become possible.

According to the present invention, the electrical signals converted from the optical signals received through a transmission line are converted into digital signals that are used to determine quality of the optical signals. The reliability information that indicates quality of the optical signals is produced based on the digital signals and given to the error-correction decoding circuit. The identification level control signals based on the reliability information are given to the multilevel identification unit. The multilevel identification unit identifies the electrical signals at the timing of the clock that is extracted from the electrical signals by variably controlling the identification levels in accordance with the identification control signals, namely, in accordance with the optical reception quality that is indicated by the reliability information. The identified multinary serial signals are converted into parallel signals and given to the error-correction decoding circuit. Therefore, the error-correction decoding circuit can correct errors based on the parallel multinary signals that are weighted in accordance with the optical reception quality. This kind of error-correction decoding circuit can be implemented using CMOS-LSI that can make a large-scale integration and low power consumption realized. As a result, a miniaturization and a low power consumption of the optical receiver become possible.

According to the present invention, any single information among the optical reception power, the optical S/N ratio, and the optical wavelength or information of any random combination of the optical reception power, the optical S/N ratio, and the optical wavelength can be used as the reliability information.

According to the present invention, the error-correction ability is enhanced because the reliability information is produced in synchronization with the identification timing of the clock.

According to the present invention, since the reliability information is applied to an error-correction code that treats a set of n bits, where n is a positive integer, as one symbol and the reliability information is produced for each symbol, the processing system that produces the reliability information can be simplified.

### INDUSTRIAL APPLICABILITY

As described above, the optical receiver according to the present invention is suitable for a long-haul and high-speed optical transmission system.

## Claims

1. An optical receiver comprising:
an optical-electrical conversion unit that converts optical signals received through a transmission line into first electrical signals and second electrical signals;
a multilevel identification unit that identifies the first electrical signals based on a plurality of identification levels and produces multinary identification signals based on the result of identification of the first electrical signals;
an optical reception quality determining unit that determines, based on the second electrical signals, quality of the optical signals and produces reliability information that indicates the quality; and
an error-correction decoding unit that corrects errors based on the multinary identification signals and the reliability information, and outputs error-corrected signals.

2. The optical receiver according to claim 1, wherein the reliability information is any single information among the optical reception power, the optical S/N ratio, and the optical wavelength, or information of any random combination of the optical reception power, the optical S/N ratio, and the optical wavelength.

3. The optical receiver according to claim 1, wherein the reliability information is produced in synchronization with the identification timing of the clock.

4. The optical receiver according to claim 1, wherein the reliability information is produced for every single symbol by using an error-correction code that treats a set of n bits, where n is a positive integer, as one symbol.

5. An optical receiver comprising:
an optical-electrical conversion unit that converts optical signals received through a transmission line into first electrical signals and second electrical signals;
an optical reception quality determining unit that determines, based on the first electrical signals, quality of the optical signals and produces reliability information that indicates the quality;
a multilevel identification unit that variably controls a plurality of identification levels to identify the second electrical signals, based on the reliability information, identifies the second electrical signals based on the varied identification levels, and produces multinary identification signals based on the result of identification of the second electrical signals; and
an error-correction decoding unit that corrects errors based on the multinary identification signals, and outputs the error-corrected signals.

6. The optical receiver according to claim 5, wherein the reliability information is any single information among the optical reception power, the optical S/N ratio, and the optical wavelength, or information of any random combination of the optical reception power, the optical S/N ratio, and the optical wavelength.

7. The optical receiver according to claim 5, wherein the reliability information is produced in synchronization with the identification timing of the clock.

8. The optical receiver according to claim 5, wherein the reliability information is produced for every single symbol by using an error-correction code that treats a set of n bits, where n is a positive integer, as one symbol.

9. An optical receiver comprising:
a first optical coupler that splits optical signals received through a transmission line into two lights;
a first photodiode that converts one of the split lights into electrical signals;
a clock extracting circuit that extracts a clock from output signals of the first photodiode;
a multilevel identification unit that identifies the output signals of the first photodiode based on a plurality of identification levels at a timing of the clock, and outputs multinary serial signals based on the result of identification of the output signals from the first photodiode;
a serial-parallel conversion circuit that converts the multinary serial signals into multinary parallel signals;
a second optical coupler that extracts a desired wavelength component from other of the split lights;
a second photodiode that converts the output light from the second optical coupler into electrical signals;
an A/D converter that converts the output signals of the second photodiode into digital signals;
an optical reception quality calculating circuit that calculates, based on the digital signals, a reliability information that indicates quality of the optical signals; and
an error-correction decoding circuit that corrects errors based on the multinary identification signals and the reliability information, and outputs error-corrected signals.

10. The optical receiver according to claim 9, wherein the reliability information is any single information among the optical reception power, the optical S/N ratio, and the optical wavelength or information of any random combination of the optical reception power, the optical S/N ratio, and the optical wavelength.

11. The optical receiver according to claim 9, wherein the reliability information is produced in synchronization with the identification timing of the clock.

12. The optical receiver according to claim 9, wherein the reliability information is produced for every single symbol by using an error-correction code that treats a set of n bits, where n is a positive integer, as one symbol.

13. An optical receiver comprising:
a first optical coupler that splits optical signals received through a transmission line into two lights;
a second optical coupler that extracts a desired wavelength component from one of the split lights;
a first photodiode that converts output light of the second optical coupler into electrical signals;
an A/D converter that converts the output signals of the first photodiode into digital signals;
an optical reception calculating circuit that calculates, based on the digital signals, reliability information that indicates an optical reception quality;
an identification value control circuit that produces identification level control signals to variably control values of a plurality of identification levels according to the reliability information;
a second photodiode that converts other of the split lights into electrical signals;
a multilevel identification unit that identifies output signals of the second photodiode based on the plurality of identification levels at a timing of the clock, and outputs multinary serial signals based on the result of identification of the output signals of the second photodiode;
a serial-parallel conversion circuit that converts the multinary serial signals into multinary parallel signals; and
an error-correction decoding circuit that corrects errors using the parallel signals, and outputs error-corrected parallel signals.

14. The optical receiver according to claim 13, wherein the reliability information is any single information among the optical reception power, the optical S/N ratio, and the optical wavelength, or information of any random combination of the optical reception power, the optical S/N ratio, and the optical wavelength.

15. The optical receiver according to claim 13, wherein the reliability information is produced in synchronization with the identification timing of the clock.

16. The optical receiver according to claim 13, wherein the reliability information is produced for every single symbol by using an error-correction code that treats a set of n bits, where n is a positive integer, as one symbol.

17. An optical receiver comprising:
a photodiode that converts optical signals received through a transmission line into electrical signals;
a clock extracting circuit that extracts a clock from the electrical signals;
a multilevel identification unit that outputs multinary serial signals by identifying the electrical signals based on a plurality of identification levels at the clock timing;
a serial-parallel conversion circuit that converts the multinary serial signals into multinary parallel signals;
an A/D converter that converts the electrical signals into digital signals;
an optical reception quality calculating circuit that calculates, based on the digital signals, reliability information that indicates quality of the optical signals; and
an error-correction decoding circuit that corrects errors based on the multinary identification signals and the reliability information, and outputs error-corrected signals.

18. The optical receiver according to claim 17, wherein the reliability information is any single information among the optical reception power, the optical S/N ratio, and the optical wavelength, or information of any random combination of the optical reception power, the optical S/N ratio, and the optical wavelength.

19. The optical receiver according to claim 17, wherein the reliability information is produced in synchronization with the identification timing of the clock.

20. The optical receiver according to claim 17, wherein the reliability information is produced for every single symbol by using an error-correction code that treats a set of n bits, where n is a positive integer, as one symbol.

21. An optical receiver comprising:
a photodiode that converts optical signals received through a transmission line into electrical signals;
an A/D converter that converts the electrical signals into digital signals;
an optical reception quality calculating circuit that calculates, based on the digital signals, reliability information that indicates a quality of the optical signals;
an identification value control circuit that produces identification level control signals to variably control values of a plurality of identification levels according to the reliability information;
a clock extracting circuit that extracts a clock from the electrical signals;
a multilevel identification unit that outputs multinary serial signals by variably controlling the identification levels in accordance with the identification level control signals when identifying the electrical signals based on the plurality of identification levels at the clock timing;
a serial-parallel conversion circuit that converts the multinary serial signals into multinary parallel signals; and
an error-correction decoding circuit that corrects errors using the parallel signals, and outputs error-corrected parallel signals.

22. The optical receiver according to claim 21, wherein the reliability information is any single information among the optical reception power, the optical S/N ratio, and the optical wavelength, or information of any random combination of the optical reception power, the optical S/N ratio, and the optical wavelength.

23. The optical receiver according to claim 21, wherein the reliability information is produced in synchronization with the identification timing of the clock.

24. The optical receiver according to claim 21, wherein the reliability information is produced for every single symbol by using an error-correction code that treats a set of n bits, where n is a positive integer, as one symbol.
